# EUROPEAN PATENT APPLICATION

(11) **EP 4 170 901 A1**
(43) Date of publication of application: **26.04.2023**
(21) Application number: 21829471.8
(22) Date of filing: 22.06.2021
(51) Int. Cl.: H03F 1/02

(54) **DOHERTY POWER AMPLIFIER AND POWER AMPLIFICATION METHOD**

(30) Priority: 23.06.2020 CN 202010581051
(71) Applicant: ZTE Corporation, Shenzhen, Guangdong 518057 (CN)
(72) Inventor: CHEN, Huazhang, Shenzhen, Guangdong 518057 (CN); CUI, Xiaojun, Shenzhen, Guangdong 518057 (CN); HOU, Ting, Shenzhen, Guangdong 518057 (CN); AN, Jinyuan, Shenzhen, Guangdong 518057 (CN)
(74) Representative: Canzler & Bergmeier Patentanwälte Partnerschaft mbB
(86) International application number: PCT/CN2021/101551
(87) International publication number: WO 2021/259265

(57) **Abstract**

Disclosed in the present disclosure is a Doherty power amplifier, comprising at least one carrier power amplifier and at least one peak power amplifier, which are connected in parallel. Each carrier power amplifier and each peak power amplifier comprise at least one set of carrier power amplification units and at least one set of peak power amplification units, respectively. Each set of carrier power amplification units is connected in parallel for power synthesis, each set of peak power amplification units is connected in parallel for power synthesis, each carrier power amplification unit and each peak power amplification unit comprises a two-way power amplification circuit, each two-way power amplification circuit is connected in parallel for power synthesis, and the two-way power amplification circuits each comprise medium-low power amplification tubes. The medium-low power amplification tubes are power amplification tubes the saturation power of which is less than or equal to a preset threshold. Also disclosed in the present disclosure is a power amplification method.

## Description

### CROSS-REFERENCE TO RELATED APPLICATIONS

The present disclosure claims the priority to the Chinese Patent Application No. 202010581051.3 filed on June 23, 2020, the entire contents of which are incorporated herein by reference.

### TECHNICAL FIELD

The present disclosure relates to the field of communications, and in particular, to a Doherty power amplifier and a power amplification method.

### BACKGROUND

A Remote Radio Unit (RRU) or an Active Antenna Unit (AAU), as a core subsystem in a wireless base station, processes and converts baseband digital signals into radio waves, and transmits the radio waves out through an antenna. In a front stage of a transmitting device, a radio frequency signal generated by a modulation device generally have relatively low power, and need to be amplified by a series of amplification processes to obtain enough radio frequency output power, so as to be fed to the antenna. A radio frequency power amplifier is located in a final stage of the transmitting device, and is configured to perform power amplification on the modulated radio frequency signal, so that the modulated radio frequency signal has enough radio frequency output power and then is fed to the antenna to be transmitted out. The heat consumption of the radio frequency power amplifier accounts for about 2/3 of the total heat consumption of the RRU or the AAU, and the radio frequency power amplifier is a component consuming the most energy in the wireless base station, and thus the efficiency of the radio frequency power amplifier directly affects the power consumption of the entire wireless base station, which makes relativley high efficiency is one of the most important aims during designing a power amplifier.

At present, a mature high-efficiency power amplifier most widely used in the industry is a Doherty power amplifier, which has a simple structure and relatively high efficiency and is easy to be implemented. However, although the Doherty power amplifier has the simple structure and relatively high efficiency, the Doherty power amplifier has insurmountable defects such as reduced gain, reduced bandwidth and more sensitive. Compared with a Class AB power amplifier, the gain of the Doherty power amplifier is reduced by 2dB to 3dB (decibel), because a peak power amplifier is a Class C power amplifier and has a relatively low gain, which restricts a gain of a power amplifier in the final stage. In practical applications involving high power or ultra-high power, the Doherty power amplifier can adopt multiple paths of Doherty circuits to perform power combination to further increase the output power and the efficiency, but each power combination by the Doherty circuits for increasing the efficiency causes a reduction of a bandwidth applied. With an increase of bandwidth of an operator and wide commercial application of high-band and large-bandwidth products, the bandwidth of the power amplifier is changed from a single frequency ranging from 30MHz to 75MHz to multiple frequencies and then to a 5G single frequency ranging from 200MHz to 400MHz, and are still being increased. Thus, in the era of global 5G mobile communications, how to solve the problem of bandwidth of the Doherty power amplifier to increase the efficiency of the Doherty power amplifier to the maximum extent under large-bandwidth conditions has become an urgent technical problem to be solved by those of ordinary skill in the art.

### SUMMARY

An embodiment of the present disclosure provides a Doherty power amplifier, including at least one carrier power amplifier and at least one peak power amplifier connected in parallel; the carrier power amplifier includes at least one carrier power amplifier unit connected in parallel for power combination, each carrier power amplifier unit includes two power amplifier circuits connected in parallel for power combination, and each of the two power amplifier circuits includes a medium-low power amplifier transistor; the peak power amplifier includes at least one peak power amplifier unit connected in parallel for power combination, each peak power amplifier unit includes two power amplifier circuits connected in parallel for power combination, and each of the two power amplifier circuits includes a medium-low power amplifier transistor; and the medium-low power amplifier transistor is a power amplifier transistor having saturation power less than or equal to a preset threshold.

An embodiment of the present disclosure further provides a power amplification method applicable to the Doherty power amplifier provided by the embodiment of the present disclosure, including: performing power combination by using at least one carrier power amplifier and at least one peak power amplifier; spliting a signal input into the carrier power amplifier into at least one group of signals, spliting each group of signals into two paths of signals, and performing power amplification on the two paths of signals respectively by medium-low power amplifier transistors in power amplifier circuits, so as to reduce saturation power of each medium-low power amplifier transistor, and perform power combination on output signals from two power amplifier circuits; and spliting a signal input into the peak power amplifier into at least one group of signals, spliting each group of signals into two paths of signals, and performing power amplification on the two paths of signals respectively by medium-low power amplifier transistors in power amplifier circuits, so as to reduce saturation power of each medium-low power amplifier transistor, and perform power combination on output signals from two power amplifier circuits.

### BRIEF DESCRIPTION OF DRAWINGS

The accompanying drawings are intended to provide a further understanding of the present disclosure and constitute a part of the specification. Together with implementations below, the drawings are used to explain the present disclosure, but do not constitute any limitation to the present disclosure.
FIG. 1 is a schematic structural diagram of a two-way Doherty power amplifier in the related technology;
FIG. 2a is a schematic structural diagram of a Doherty power amplifier according to the present disclosure;
FIG. 2b is a schematic structural diagram of a Doherty power amplifier according to the present disclosure; and
FIG. 2c is a schematic structural diagram of a Doherty power amplifier according to the present disclosure.

### DETAIL DESCRIPTION OF EMBODIMENTS

The implementations of the present disclosure are described in detail below with reference to the drawings. It should be understood that the implementations described herein are merely intended to illustrate and explain the present disclosure, rather than limiting the present disclosure

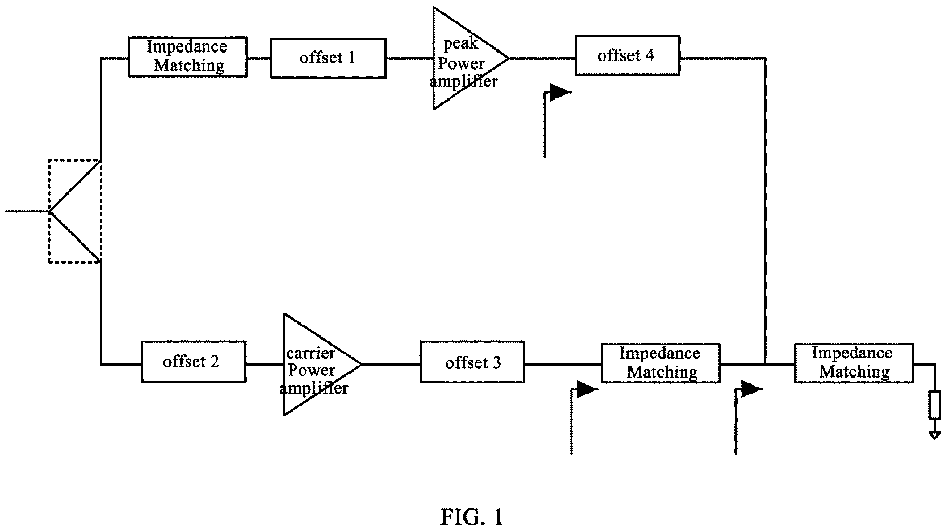

As shown in FIG. 1, a two-way Doherty power amplifier includes two power amplifiers, i.e., one carrier power amplifier and one peak power amplifier. The carrier power amplifier is a Class B power amplifier or a Class AB power amplifier, and the peak power amplifier is a Class C power amplifier. The carrier power amplifier and the peak power amplifier do not operate in turn, but the carrier power amplifier operates all the time, and the peak power amplifier operates merely during a preset peak value being reached. A 90° quarter-wavelength transformation line following the carrier power amplifier is an impedance matching line for reducing an apparent impedance of the carrier power amplifier during the peak power amplifier operating, so as to ensure that an active load impedance generated by the peak power amplifier during operating together with a following circuit is reduced, thereby increasing a current output from the carrier power amplifier. With the quarter-wavelength transformation line disposed following the carrier power amplifier, in order to enable outputs of the two power amplifiers to be the same in phase, 90° phase shift is desired previous to the peak power amplifier. A phase difference between the carrier power amplifier circuit and the peak power amplifier circuit may be adjusted by adjusting an offset 1 and an offset 2, a load impedance of the carrier power amplifier may be adjusted by adjusting an offset 3, and by adjusting an offset 4, the peak power amplifier is to be ensured in a disconnected state (i.e., not to operate) during a relatively small signal is input.

If the carrier power amplifier operates as a Class B power amplifier, and a relatively small signal is input, merely the carrier power amplifier is in an operating state (i.e., merely the carrier power amplifier operates), and in response to that an output voltage of a power amplifier transistor reaches a peak saturation point, the theoretical efficiency of the carrier power amplifier can reach 78.5%. If an excitation is doubled, the output voltage of the power amplifier transistor reaching half of the peak value would be saturated, and the efficiency can also reach 78.5%, and in such case, the peak power amplifier begins to operate together with the carrier power amplifier. By adding the peak power amplifier, an effect of the peak power amplifier on a load is equivalent to connecting negative impedance in series to the load, so that, from the perspective of the carrier power amplifier, the load is reduced. Therefore, even if the output voltage of the carrier power amplifier is saturated and constant, the output power is continuously increased (with increasing of a current flowing through the load) due to the reduction of the load. In response to that the excitation reaches a peak value, the efficiency of the peak power amplifier reaches a maximum value, so that the total efficiency of the two power amplifiers is much higher than the efficiency of a single Class B power amplifier. During merely the single Class B power amplifier operating, the maximum efficiency of the power amplifier, i.e., 78.5%, is reached at the peak value; but after the peak power amplifier is added, the two power amplifiers operate together, and the efficiency of 78.5% of the Class B power amplifier is reached at half of the peak value. Thus, the Doherty structure (the Doherty power amplifier) can achieve very high efficiency (each of the power amplifiers can achieve the maximum output efficiency).

An embodiment of the present disclosure further provides a Doherty power amplifier, including at least one carrier power amplifier 1 and at least one peak power amplifier 2 connected in parallel.

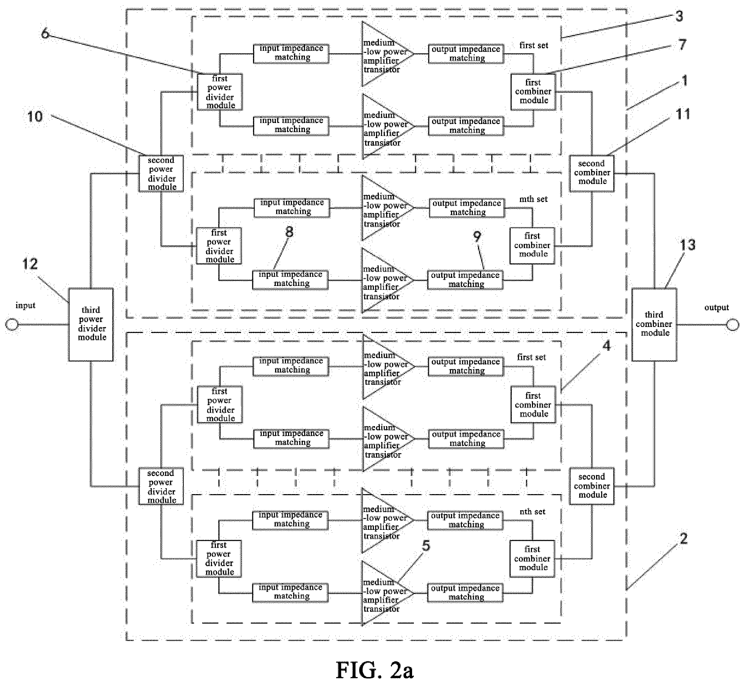

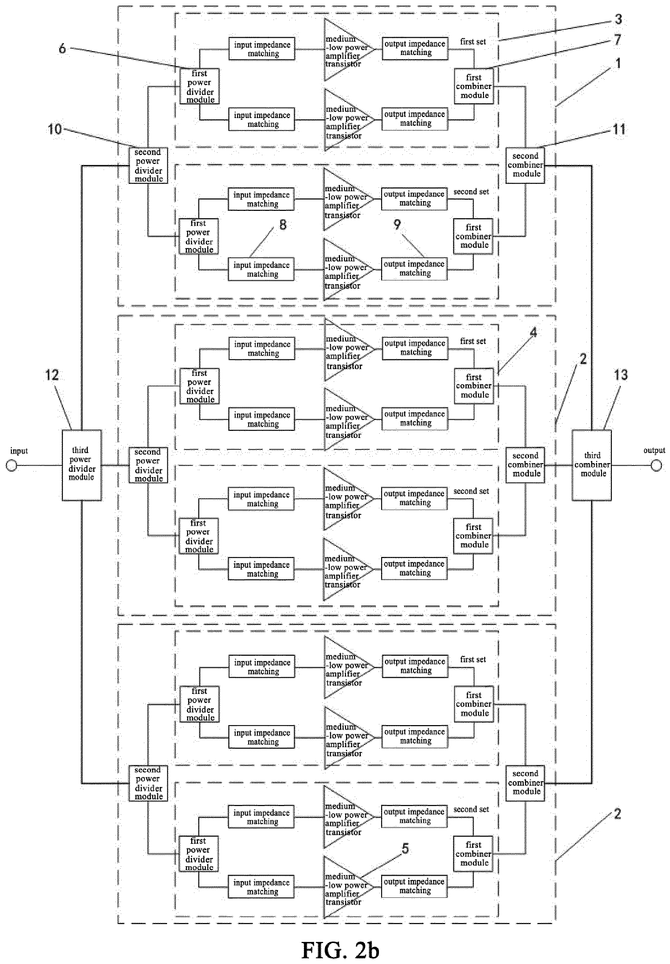

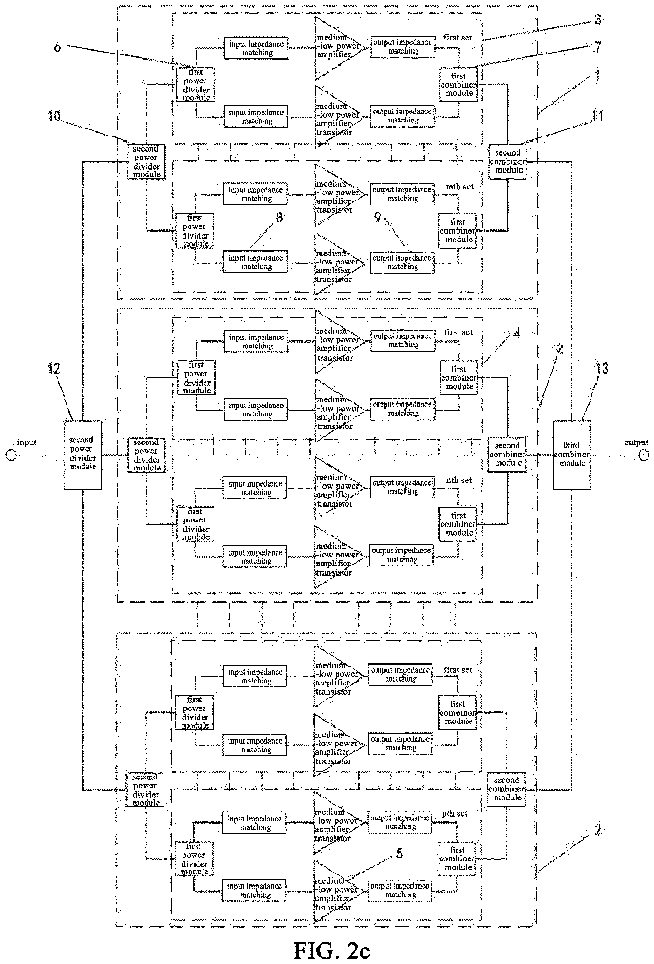

As shown in FIG. 2a, the Doherty power amplifier may include one carrier power amplifier 1 and one peak power amplifier 2; as shown in FIG. 2b, the Doherty power amplifier may include one carrier power amplifier 1 and two peak power amplifiers 2; and as shown in FIG. 2c, the Doherty power amplifier may include one carrier power amplifier 1 and more than two peak power amplifiers 2.

Each carrier power amplifier 1 may include m carrier power amplifier units 3, and the m carrier power amplifier units 3 are connected in parallel for power combination. Each carrier power amplifier unit 3 includes two power amplifier circuits connected in parallel for power combination, and each power amplifier circuit includes a medium-low power amplifier transistor 5 having saturation power less than or equal to a preset threshold.

Each peak power amplifier 2 may include n peak power amplifier units 4, and the n peak power amplifier units 4 are connected in parallel for power combination. Each peak power amplifier unit 4 includes two power amplifier circuits connected in parallel for power combination, and each power amplifier circuit includes a medium-low power amplifier transistor 5 having saturation power less than or equal to the preset threshold.

It should be noted that each of m and n is a natural number greater than or equal to 1, values of m and n are not particularly limited in the embodiment of the present disclosure, and the number of the carrier power amplifiers 1 and the number of the peak power amplifiers 2 in the Doherty power amplifier are not particularly limited in the embodiment of the present disclosure as well.

In some implementations, the preset threshold may be about 100W.

In the Doherty power amplifier provided by the embodiment of the present disclosure, each of the carrier power amplifier and the peak power amplifier includes at least one power amplifier unit, and in response to that more than one power amplifier units are included, the power amplifier units are connected in parallel, and each power amplifier unit is formed by connecting two power amplifier circuits in parallel, so that the saturation power of the power amplifier transistor in each power amplifier circuit can be reduced, and since the medium-low power amplifier transistor, having characteristics such as a relatively small internal parasitic parameter, a relatively high impedance and a relatively low loss, is adopted in each circuit for power amplification, a bandwidth to be supported by the Doherty power amplifier can be increased. Thus, with a same output power, the Doherty power amplifier provided by the embodiment of the present disclosure can support a larger bandwidth and has higher efficiency compared with the Doherty power amplifier in the related technology, and a conflict between the efficiency and the bandwidth can be solved. In addition, since the medium-low power amplifier transistor can be flexibly designed and is easily to be packaged, the Doherty power amplifier provided by the embodiment of the present disclosure can be easily to be implemented.

In the Doherty power amplifier provided by the embodiment of the present disclosure, each of the carrier power amplifier 1 and the peak power amplifier 2 may be implemented by at least one group of middle-low power amplifiers, that is, at least two middle-low power amplifier transistors 5 are used to perform the power combination, so as to perform a power amplification function of each of the carrier power amplifier circuit and the peak power amplifier circuit. Thus, as compared with a designed circuit of the Doherty power amplifier in the related technology, the saturation power of the power amplifier transistor in each power amplifier circuit can be reduced by at least about half, and a parasitic parameter of the power amplifier transistor can be reduced by about 50% at least. The efficiency of the Doherty power amplifier provided by the embodiment of the present disclosure is significantly increased for the radio frequency power amplification supporting a signal bandwidth ranging from 100MHz to 200MHz.

In some implementations, with reference to FIG. 2a, FIG. 2b, and FIG. 2c, each of the carrier power amplifier unit 3 and the peak power amplifier unit 4 may further include a first power divider module 6 and a first combiner module 7, each first power divider module 6 is connected to input ends of the two power amplifier circuits in the carrier power amplifier unit 3 or the peak power amplifier unit 4 to which the first power divider module 6 belongs, and each first combiner module 7 is connected to output ends of the two power amplifier circuits in the carrier power amplifier unit 3 or the peak power amplifier unit 4 to which the first combiner module 7 belongs.

In some implementations, with reference to FIG. 2a, FIG. 2b, and FIG. 2c, each power amplifier circuit in each of the carrier power amplifier unit 3 and the peak power amplifier unit 4 may further include an input impedance matching module 8 and an output impedance matching module 9, each input impedance matching module 8 is respectively connected to an input end of the middle-low power amplifier transistor 5 and the first power divider module 6 in the power amplifier circuit to which the input impedance matching module 8 belongs, and each output impedance matching module 9 is respectively connected to an output end of the middle-low power amplifier transistor 5 and the first combiner module 7 in the power amplifier circuit to which the output impedance matching module 9 belongs.

In some implementations, with reference to FIG. 2a, FIG. 2b, and FIG. 2c, the input impedance matching module 8 and the output impedance matching module 9 may be microstrip circuits, capacitors, or inductors.

Considering the medium-low power amplifier transistor being used, the input impedance matching module 8 and the output impedance matching module 9 may be implemented by adopting any one of technologies of microstrip circuits, capacitive devices, and inductance devices, or by adopting a combination thereof. In order to achieve impedance matching by the input impedance matching module 8 and the output impedance matching module 9, lengths and widths of microstrip lines, capacitance values of the capacitive devices, inductance values of the inductance devices may be adjusted, so as to meet performance requirements of an operation band, such as gain, output power and efficiency.

In some implementations, with reference to FIG. 2a, FIG. 2b, and FIG. 2c, each carrier power amplifier 1 may further include a second power divider module 10 and a second combiner module 11, each second power divider module 10 is connected to the first power divider module 6 of each carrier power amplifier unit 3 in the carrier power amplifier 1 to which the second power divider module 10 belongs, and each second combiner module 11 is connected to the first combiner module 7 of each carrier power amplifier unit 3 in the carrier power amplifier 1 to which the second combiner module 11 belongs. Each peak power amplifier 2 may further include a second power divider module 10 and a second combiner module 11, each second power divider module 10 is connected to the first power divider module 6 of each peak power amplifier unit 4 in the peak power amplifier 2 to which the second power divider module 10 belongs, and each second combiner module 11 is connected to the first combiner module 7 of each peak power amplifier unit 4 in the peak power amplifier 2 to which the second combiner module 11 belongs.

In some implementations, with reference to FIG. 2a, FIG. 2b, and FIG. 2c, the Doherty power amplifier may further include a third power divider module 12 and a third combiner module 13. The third power divider module 12 is a power divider module for a Doherty structure, and the third combiner module 13 is a combiner module for a Doherty structure. The third power divider module 12 is respectively connected to the second power divider module 10 of each carrier power amplifier 1 and the second power divider module 10 of each peak power amplifier 2, and the third combiner module 13 is respectively connected to the second combiner module 11 of each carrier power amplifier 1 and the second combiner module 10 of each peak power amplifier first power 2.

An external input signal is input into the Doherty power amplifier through the third power divider module, and an output signal obtained by performing power amplification on the external input signal through the Doherty power amplifier is output through the third combiner module 13.

In some implementations, with reference to FIG. 2a, FIG. 2b, and FIG. 2c, all input signals into the third combiner module 13 are the same in phase; all input signals into the second combiner module 11 of each of the carrier power amplifier 1 and the peak power amplifier 2 are the same in phase; and all input signals into the first combiner module 7 of each of the carrier power amplifier unit 3 and the peak power amplifier unit 4 are the same in phase. That is, signals respectively output from second combiner modules 11 and input into the same third combiner module 13 are the same in phase, signals respectively output from first combiner modules 7 and input into the same second combiner module 11 are the same in phase, and signals respectively output from two power amplifier circuits and input into the same first combiner module 7 are the same in phase.

In some implementations, with reference to FIG. 2a, FIG. 2b, and FIG. 2c, one carrier power amplifier 1 may be provided, and more than one peak power amplifiers 2 may be provided, and each of the peak power amplifiers 2 may include a same number of peak power amplifier units 4, or different peak power amplifiers 2 may include different numbers of peak power amplifier units 4. That is, for different peak power amplifiers 2, values of n may be the same or different.

In some implementations, with reference to FIG. 2a, FIG. 2b, and FIG. 2c, the number of the carrier power amplifier units 3 and the number of the peak power amplifier units 4 may be the same or different, that is, the value of m and the value of n may be the same or different.

The Doherty power amplifier shown in FIG. 2a includes one carrier power amplifier 1 and one peak power amplifier 2, the carrier power amplifier 1 includes m carrier power amplifier units 3, and the peak power amplifier 1 includes n peak power amplifier units 4, and each of m and n is a natural number greater than or equal to 1. The value of m may be equal to or different from the value of n, and values of m and n may be determined according to bandwidth and efficiency requirements of the Doherty power amplifier in particular applications.

The Doherty power amplifier shown in FIG. 2b includes one carrier power amplifier 1 and two peak power amplifiers 2, the carrier power amplifier 1 includes two carrier power amplifier units 3, and each peak power amplifier 2 includes two peak power amplifier units 4.

If a design of the Doherty power amplifier in the related technology is adopted, saturation power of at least about 600W is desired for implementing a power amplifier having output power of about 100W; and if the power amplifier having the output power of about 100W is implemented by adopting the three-way Doherty circuit shown in FIG. 2b, considering requirements such as layout size, efficiency and cost, the saturation power of each power amplifier transistor is desired to be at least about 200W. Taking the Doherty power amplifier shown in FIG. 2b as an example, in the Doherty power amplifier provided by the embodiment of the present disclosure, each of the carrier power amplifier and the peak power amplifiers is implemented by two groups of middle-low power amplifiers, a power amplification function of each carrier power amplification branch or each peak power amplification branch is implemented by four middle-low power amplifier transistors for power combination, so that the saturation power of each power amplifier transistor may be reduced to about 50W, and the parasitic parameter of each power amplifier transistor may be reduced by about 75% at least. Thus, both efficiency and bandwidth to be supported by the Doherty power amplifier provided by the embodiment of the present disclosure can be significantly increased.

The Doherty power amplifier shown in FIG. 2c includes one carrier power amplifier 1 and k peak power amplifiers 2, the carrier power amplifier 1 includes m carrier power amplifier units 3, the first peak power amplifier 2 includes n peak power amplifier units 4, the k^{th} peak power amplifier 2 includes p peak power amplifier units 4, and each of m, n, p and k is a natural number greater than or equal to 2. The value of n may be equal to or different from the value of p, the value of m may be equal to or different from the value of n, the value of m may be equal to or different from the value of p, and values of m, n, p and k may be all determined according to bandwidth and efficiency requirements of the Doherty power amplifier in particular applications.

In some implementations, the middle-low power amplifier transistor in each power amplifier circuit may be packaged independently, or the middle-low power amplifier transistors in multiple power amplifier circuits may be packaged together.

In the Doherty power amplifier provided by the embodiment of the present disclosure, the middle-low power amplifier transistor in each branch may be packaged in a single device, or the middle-low power amplifier transistors in two branches may be packaged in a single device, or even the middle-low power amplifier transistors in four branches may be packaged in a single device, and a packaging operator can package middle-low power amplifier transistors in an even number of branches in a single device as desired.

Based on the same technical concept, an embodiment of the present disclosure further provides a power amplification method, applied to the Doherty power amplifier provided by the embodiment of the present disclosure, including: performing power combination by using at least one carrier power amplifier and at least one peak power amplifier.

Specifically, a signal input into the carrier power amplifier is split into at least one group of signals, each group of signals is split into two paths of signals, and power amplification is performed on the two paths of signals respectively by medium-low power amplifier transistors in power amplifier circuits, so as to reduce saturation power of each medium-low power amplifier transistor, and power combination is performed on output signals from two power amplifier circuits; and a signal input into the peak power amplifier is split into at least one group of signals, each group of signals is split into two paths of signals, and power amplification is performed on the two paths of signals respectively by medium-low power amplifier transistors in power amplifier circuits, so as to reduce saturation power of each medium-low power amplifier transistor, and power combination is performed on output signals from two power amplifier circuits.

It should be understood that the above implementations are merely exemplary implementations adopted to illustrate the principle of the present disclosure, and the present disclosure is not limited thereto. Without departing from the spirit and essence of the present disclosure, those of ordinary skill in the art may make various modifications and improvements to the present disclosure, and those modifications and improvements should be considered to fall within the scope of the present disclosure.

## Claims

1. A Doherty power amplifier, comprising at least one carrier power amplifier and at least one peak power amplifier connected in parallel;
the carrier power amplifier comprises at least one carrier power amplifier unit connected in parallel for power combination, each carrier power amplifier unit comprises two power amplifier circuits connected in parallel for power combination, and each of the two power amplifier circuits comprises a medium-low power amplifier transistor;
the peak power amplifier comprises at least one peak power amplifier unit connected in parallel for power combination, each peak power amplifier unit comprises two power amplifier circuits connected in parallel for power combination, and each of the two power amplifier circuits comprises a medium-low power amplifier transistor; and
the medium-low power amplifier transistor is a power amplifier transistor having power less than or equal to a preset threshold.

2. The Doherty power amplifier of claim 1, wherein each carrier power amplifier unit further comprises a first power divider module and a first combiner module, the first power divider module is respectively connected to input ends of the two power amplifier circuits in the carrier power amplifier unit to which the first power divider module belongs, and the first combiner module is respectively connected to output ends of the two power amplifier circuits in the carrier power amplifier unit to which the first combiner module belongs; and
each peak power amplifier unit further comprises a first power divider module and a first combiner module, the first power divider module is respectively connected to input ends of the two power amplifier circuits in the peak power amplifier unit to which the first power divider module belongs, and the first combiner module is respectively connected to output ends of the two power amplifier circuits in the peak power amplifier unit to which the first combiner module belongs.

3. The Doherty power amplifier of claim 2, wherein each power amplifier circuit in each of the carrier power amplifier unit and the peak power amplifier unit further comprises an input impedance matching module and an output impedance matching module, the input impedance matching module is respectively connected to an input end of the middle-low power amplifier transistor and the first power divider module in the power amplifier circuit to which the input impedance matching module belongs, and the output impedance matching module is respectively connected to an output end of the middle-low power amplifier transistor and the first combiner module in the power amplifier circuit to which the output impedance matching module belongs.

4. The Doherty power amplifier of claim 3, wherein each of the input impedance matching module and the output impedance matching module is any one or any combination of a microstrip circuit, a capacitor, and an inductor.

5. The Doherty power amplifier of claim 3, wherein each carrier power amplifier further comprises a second power divider module and a second combiner module, the second power divider module is connected to the first power divider module of each carrier power amplifier unit in the carrier power amplifier to which the second power divider module belongs, and the second combiner module is connected to the first combiner module of each carrier power amplifier unit in the carrier power amplifier to which the second combiner module belongs; and
each peak power amplifier further comprises a second power divider module and a second combiner module, the second power divider module is connected to the first power divider module of each peak power amplifier unit in the peak power amplifier to which the second power divider module belongs, and the second combiner module is connected to the first combiner module of each peak power amplifier unit in the peak power amplifier to which the second combiner module belongs.

6. The Doherty power amplifier of claim 5, further comprising: a third power divider module and a third combiner module, with the third power divider module being a power divider module for a Doherty structure, and the third combiner module being a combiner module for a Doherty structure; and
the third power divider module is respectively connected to the second power divider module of each carrier power amplifier and the second power divider module of each peak power amplifier, and the third combiner module is respectively connected to the second combiner module of each carrier power amplifier and the second combiner module of each peak power amplifier.

7. The Doherty power amplifier of claim 6, wherein all input signals into the third combiner module are the same in phase;
all input signals into the second combiner module in each carrier power amplifier or each peak power amplifier are the same in phase; and
all input signals into the first combiner module in each carrier power amplifier unit or each peak power amplifier unit are the same in phase.

8. The Doherty power amplifier of any one of claims 1 to 7, wherein one carrier power amplifier is provided, more than one peak power amplifier is provided, and numbers of the peak power amplifier units in different peak power amplifiers are the same or different.

9. The Doherty power amplifier of any one of claims 1 to 7, wherein a number of carrier power amplifier units is the same or different from a number of peak power amplifier units.

10. The Doherty power amplifier of any one of claims 1 to 7, wherein the middle-low power amplifier transistor in each power amplifier circuit is packaged independently, or middle-low power amplifier transistors in multiple power amplifier circuits are packaged together.

11. A power amplification method, applied to the Doherty power amplifier of any one of claims 1 to 10, comprising:
performing power combination by using at least one carrier power amplifier and at least one peak power amplifier;
wherein a signal input into the carrier power amplifier is split into at least one group of signals, each group of signals is split into two paths of signals, power amplification is performed on the two paths of signals respectively by medium-low power amplifier transistors in power amplifier circuits, so as to reduce saturation power of each medium-low power amplifier transistor, and power combination is performed on output signals from two power amplifier circuits; and
a signal input into the peak power amplifier is split into at least one group of signals, each group of signals is split into two paths of signals, power amplification is performed on the two paths of signals respectively by medium-low power amplifier transistors in power amplifier circuits, so as to reduce saturation power of each medium-low power amplifier transistor, and power combination is performed on output signals from two power amplifier circuits.
